# EUROPEAN PATENT SPECIFICATION

(11) **EP 0 885 469 B1**
(45) Date of publication and mention of the grant of the patent: **05.11.2003**
(21) Application number: 97907511.6
(22) Date of filing: 04.03.1997
(51) Int. Cl.: H01P 5/10

(54) **A HIGH FREQUENCY BALUN PROVIDED IN A MULTILAYER SUBSTRATE**
HOCHFREQUENZ-SYMMETRIEREINRICHTUNG IN EINEM MEHRSCHICHTSUBSTRAT
BALUN HAUTE FREQUENCE DANS UN SUBSTRAT MULTICOUCHE

(30) Priority: 05.03.1996 US 610934
(43) Date of publication of application: 23.12.1998
(73) Proprietor: TELEFONAKTIEBOLAGET L M ERICSSON (publ), 126 25 Stockholm (SE)
(72) Inventor: DABROWSKI, Jerzy, S-183 34 Täby (SE)
(74) Representative: Boesen, Johnny Peder
(86) International application number: PCT/SE97/00364
(87) International publication number: WO 97/033337

(56) References cited:
- US-A- 4 016 463
- US-A- 4 758 922
- US-A- 5 451 914

## Description

### BACKGROUND

The present invention is generally directed to baluns and, more particularly, to baluns which are implemented as part of a multilayer structure.

A balun (which term comes from the phrase BALanced to UNbalanced) is a passive three port electronic circuit used for conversion between symmetrical and nonsymmetrical transmission lines. The signal, for example incoming to a nonsymmetrical port, is divided between two symmetrical ports providing signals which have the same amplitude but with phases which are 180 degrees offset relative to one another on their outputs. Baluns are used, for example, in the construction of balanced amplifiers, mixers and antenna systems.

The balun construction depends on the intended operating frequency range. In the microwave frequency range, where the size of the structure is comparable to the wavelength of the signal, distributed element circuit technology is commonly used. In lower frequency ranges, e.g., up to 2500 MHz, transformer solutions are common in which wires are wound spirally around a highly permeable magnetic core. These conventional balun configurations suffer from a number of problems.

The transformer solutions, using the phenomenon of magnetic coupling between transformator wires, are theoretically wide band circuits. In practice, however, compensation for eigen capacitances is needed, especially in the frequency range 400 to 2500 MHz. This means that the physical construction of the transformer-type baluns has to be specifically optimized for operation within its operating frequency bandwidth. Additionally, it is difficult to accurately set the length of the wires to be wound about the core so that baluns which are designed to be the same, actually have substantially the same electrical characteristics.

Most existing baluns operating in the high (e.g., greater than 2500 MHz) frequency range, give good balun performance only if both symmetrical ports are well matched. In many applications, power matching of the symmetrical ports is not desirable for other reasons. For example, power matching on the symmetrical inputs of mixers or amplifiers worsens their noise parameters. Thus, a compromise between power matching and noise matching is needed.

Moreover, ongoing miniaturization of electronic structures is, in turn, causing the miniaturization of baluns. For example, baluns used in the frequency range 400 to 2000 MHz are not usually bigger than about 20 mm² and are designed for automatic surface mounting onto the end product. However. during the production of the baluns themselves, manual mounting is still used because the wires require manual winding around the core and the ends of the wires need to be inserted into electrical connectors on the end product. Manual mounting is expensive, time consuming and causes spread in the parameters of the end product, e.g., a radio receiver, of which the balun is just one of many components.

US 5 451 914 discloses a radio frequency balun transformer comprising a multilayer structure on top of which components may be placed. Two of the layers comprise coupled coils looped in opposite directions and forming the transformer. However, this document does not relate to handling different operating frequency ranges.

Thus, it would be desirable to provide a balun having better symmetry when working with unmatched loading, which do not require different physical constructions to handle different operating frequency ranges, and which are less expensive to manufacture by allowing automatic integration of the balun with other circuit components as opposed to manual mounting.

### SUMMARY

These and other drawbacks and limitations of conventional baluns are overcome according to exemplary embodiments of the present invention. Baluns according to the present invention use both distributed and discrete elements connected together in a multilayer dielectric structure. As distributed elements. coupled striplines are provided in the multilayer dielectric structure. The discrete components are placed on the surface of the multilayer structure and connected with the distributed elements through via-holes. This provides a number of advantageous balun characteristics.

For example, within a range bounded by the characteristics of the dielectric material used in the multilayer structure, the operating frequency range of the balun can be adjusted simply by changing values of the discrete components used to fabricate the balun. In this way, the operating frequency of the balun can be easily changed without necessitating a completely new balun construction. This is a great advantage as compared to, for example, transformer-type baluns for which a completely new construction design was required for different operating frequency ranges.

By providing the balun as part of a multilayer structure using known printed circuit and discrete component integration techniques, production gilt is increased and manual mounting of baluns is eliminated. This serves to reduce expense of the end product in which the balun is incorporated.

By fabricating the balun as a multilayer structure, the distributed elements can be provided in a layer which is embedded below that on which the discrete components are mounted. This allows the top layer surface area required for the balun to be reduced which further promotes miniaturization of the products in which the balun is incorporated.

### BRIEF DESCRIPTION OF THE DRAWINGS

The foregoing, and other, objects, features and advantages of the present invention will be more readily understood upon reading the following detailed description in conjunction with the drawings in which:
Figure 1 is a top view of an exemplary multilayer structure in which baluns according to the present invention can be implemented;
Figure 2 is a sectional view of an exemplary multilayer structure in which baluns according to the present invention can be implemented; and
Figure 3 illustrates an exemplary circuit topology of baluns according to the present invention.

### DETAILED DESCRIPTION

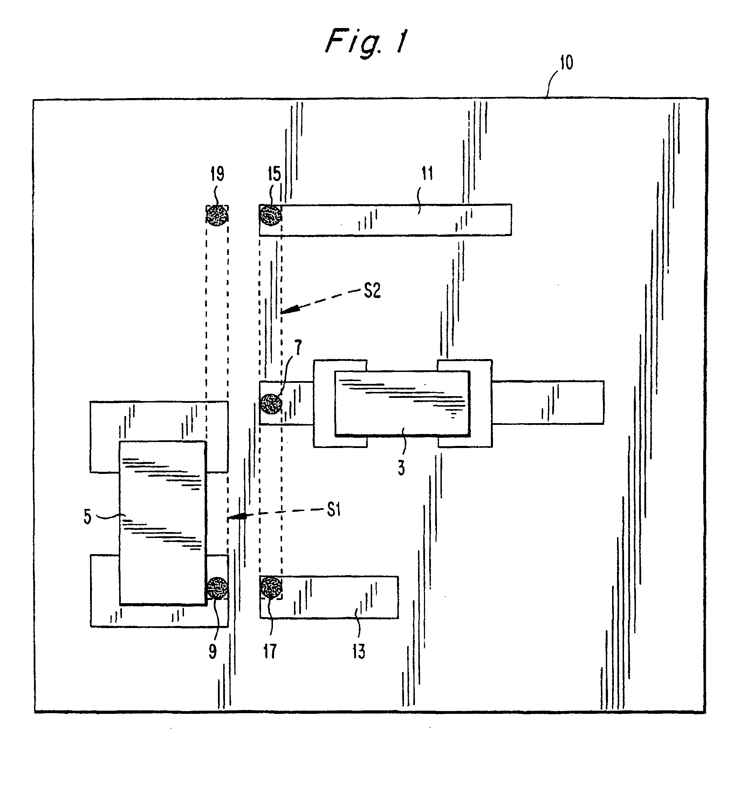

An example of a multilayer structure in which baluns according to the present invention can be implemented is shown (in a top view) as Figure 1. Therein, a coupled pair of striplines S1 and S2 are illustrated as hidden (i.e., by way of the dotted lines) since the coupled striplines are embedded in a lower layer of the multilayer structure 10. A stripline is a well known transmission line which can be formed as a conductive metal trace placed in a dielectric media with two parallel ground planes on both sides of the dielectric surface. A coupled stripline is a structure using two striplines having a constant distance between them. In a multilayer structure, coupled striplines can be made as two parallel traces on the same layer with ground planes on layers above and below the layer with traces, or as parallel traces placed on two adjacent layers. The remaining components illustrated in Figure 1 are on the surface or top layer of the multilayer structure 10. For example, the multilayer structure 10 could include surface mounted devices 3 and 5. Surface mounted devices 3 and 5 can be electrically connected to the coupled striplines S2 and S1, respectively, using vias (thru holes) 7 and 9, respectively. As is well known in the art. vias are apertures formed in multilayer structures which are plated with conductive material to establish electrical connections at desired points between different layers in the multilayer structure. Additionally, the exemplary multilayer structure 10 shown in Figure 1 includes microstrips 11 and 13 on the surface or top layer. As is well known in the art, microstrips are controlled impedance microwave frequency transmission lines which are formed as conductive metal traces on one side of a dielectric surface with a ground plane on the other side of the dielectric surface. Microstrips 11 and 13 are connected to one of the coupled striplines S2 by via-holes 15 and 17, respectively. Also illustrated in Figure 1 is a via 19 which connects the coupled striplines S and S2 with a ground plane.

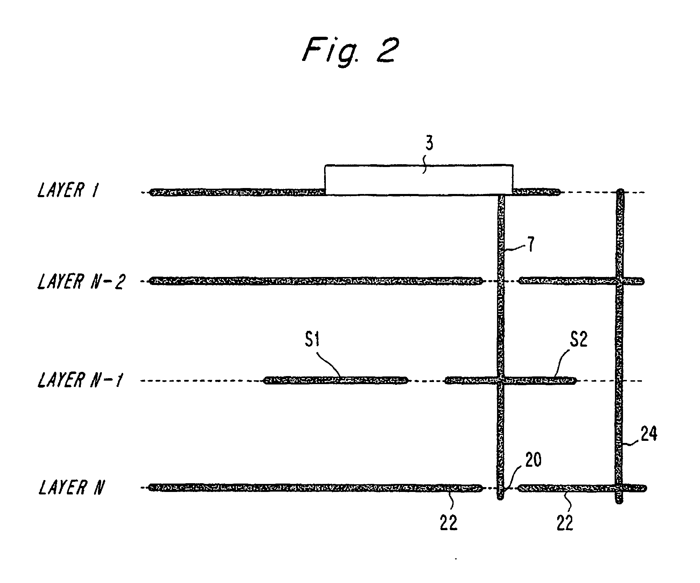

Figure 2 illustrates a side view of an exemplary multilayer structure in which baluns according to the present invention can be implemented. Although the side view portrays a slightly different component configuration than the multilayer structure of Figure 1, similar reference numerals are used to refer to similar elements. For example, the top layer (denoted Layer 1 in Figure 2) includes a surface mounted device 3. This surface mounted device 3 is connected to one of the coupled striplines S2 which have been fabricated in Layer N-1. In this example, the multilayer structure has four layers, although any number of layers which are equal to or greater than four can be used. The via 7 which interconnects surface mounted device 3 with coupled striplines S1 and S2 is isolated from the ground planes as seen, for example, at point 20 on Layer N which illustrates a separation between the via 7 and the metallized ground plane portions 22. Another conductive via 24 provides a connection between the ground plane Layers N and N-2.

Each of the four conductive layers illustrated in Figure 2 are separated from adjacent layers by a layer of dielectric material. Moreover, the discrete electrical components provided on Layer 1 of the multilayer structure are electrically isolated from the electrical components provided on Layer N-1, e.g.. coupled striplines S1 and S2, by a ground plane provided as Layer N-2. The ground plane can, for example, be a copper layer of about 17.5 mm in thickness. This helps to ensure that the operation of the components provided on Layer 1 is not affected by the provision of electrical impulses to the components on Layer N-1, e.g., by capacitive or inductive coupling effects.

The operating frequency of the balun is bounded by the electrical parameters of the dielectric layers provided in the multilayer structure (e.g., dielectric constant, dielectric losses (loss tangent) and dielectric thickness). For example, if a typical glass-fiber resin material (e.g., having a dielectric constant of 4.25, a loss tangent of 0.02 and a layer thickness of 0.5 mm) is used for the dielectric layers of Figure 2, an operating frequency of baluns according to the present invention can be set to be between 100 MHz and 2.5 GHz. The lower value is, in practice, limited by the lengths of the stripline structure. The higher frequency value is limited by losses in dielectric layers and higher wavelength transmission modes which are associated with increasing frequency (given a constant dielectric layer thickness). A significant feature of the present invention is that the operating frequency of the balun may be changed within the bounded range by changing the values of the discrete components, without changing the multilayer structure itself. These and other benefits of baluns according to the present invention will become more apparent after reviewing the detailed description of an exemplary balun circuit configuration provided below.

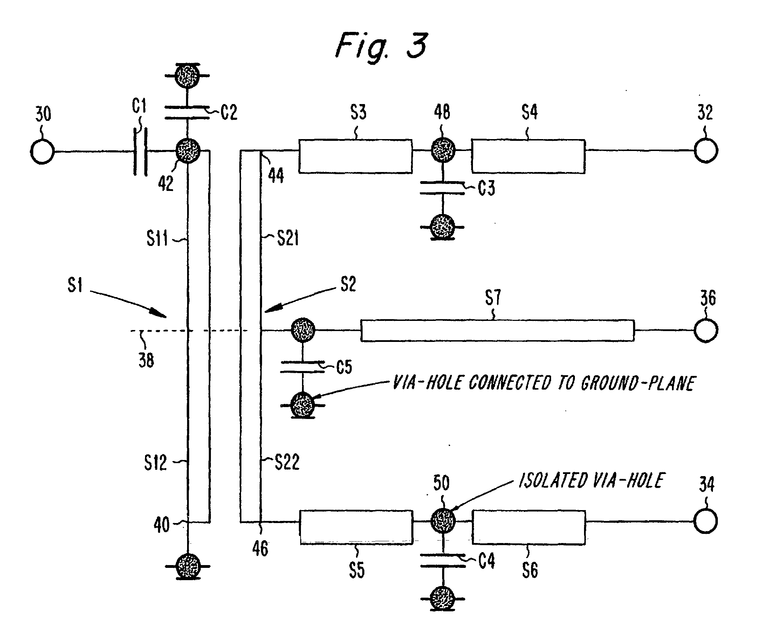

An exemplary balun according to the present invention is shown in Figure 3. In Figure 3, vias are depicted using shaded circles. As seen by the examples in this figure, some of the vias are connected to a ground plane (e.g., Layer N-2 and Layer N) while others are connections between the top surface of the multilayer structure and an embedded layer. Port 30 is the nonsymmetrical port of the balun, while ports 32 and 34 are the symmetrical outputs. Thus. ports 32 and 34 each provide an output having the same amplitude, but whose phases differ by 180 degrees (if the balun is perfectly symmetrical). Port 36 is optionally provided (as is transmission line S7) if an external bias is to be connected for biasing ports 32 and 34. Port 36 can be used. for example, to connect active devices (e.g., active amplifiers or active mixers) to bias the symmetrical output ports 32 and 34. Transmission line S7 provides electrical isolation between common node 38 and port 36. When connected to passive devices, port 36 (and transmission line S7) can be omitted.

The distributed element part of the balun includes two sections S1 and S2 of coupled transmission striplines. Section S1 includes striplines S11 and S12, while section S2 includes striplines S21 and S22. Both sections S1 and S2 can have identical characteristic impedances for even and odd modes and can have identical electrical lengths and be coupled together at common node 38 (represented by a dotted line in Figure 3). This can be accomplished by making each stripline S11, S12, S21 and S22 of the same length (e.g., 6.4 mm), same width (e.g., 0.2 mm), same thickness and providing a uniform spacing between sections S1 and S2 (e.g., 0.15 mm). Node 40 of stripline S12 is connected to the ground planes and node 42 of stripline S11 is connected to capacitors C1 and C2. The capacitors C1 and C2 have values that are chosen based upon the desired operating frequency of the balun to provide proper matching and impedance transformation for the nonsymmetrical output of the balun. Nodes 44 and 46 of striplines S21 and S22 are connected to striplines S3 and S5 and, together with capacitors C3 and C4, give proper impedance transformation at nodes 48 and 50, respectively. Symmetrical output ports 32 and 34 are connected to nodes 48 and 50 with lines S4 and S6. The proper choice of impedance values and electrical lengths for transmission line elements S3 and S4 and capacitance value of C3 on one side and substantially the same impedance values and electrical lengths for transmission line elements S5 and S6 and capacitance value for C4 on the other side, determines an output impedance of the terminating balun circuit. Those skilled in the art will appreciate that the output impedance can be varied so that the symmetrical ports provide maximal gain (power matching), minimal noise (noise matching) or a compromise between the two competing objectives depending upon the application. The value selected for capacitor C5 gives a proper symmetry of the balun so that the symmetrical outputs have substantially the same amplitude and are as close to 180 degrees offset in phase as possible. This capacitance value depends on the characteristic impedances of the coupled striplines for even and odd modes as well as the electrical lengths of sections S1 and S2 at the operating frequency of the balun. If used, the characteristic impedance and electrical length of transmission line S7 and the impedance in port 36 have to be taken into account to determine the appropriate capacitance value for C5 to maintain the balun symmetry.

As mentioned above, coupled stripline sections S1 and S2 are embedded within a multilayer structure, e.g., structure 10, while the discrete components (e.g., capacitors C1-C5) are provided on Layer 1 or the top surface of the structure. Depending on the design constraints of the balun, striplines (in an embedded layer) or microstrips (on a surface layer) can be used for transmission line elements S3, S4, S5, S6 and S7. In the example shown in Figure 3, S3 and S5 are fabricated as striplines in an embedded layer (e.g.. Layer N-1) along with coupled striplines S1 and S2. Transmission line elements S4 and S6 are fabricated as microstrips on the surface layer along with capacitors C1-C5.

According to exemplary embodiments of the present invention, baluns are constructed in a multilayer structure using distributed and discrete components such that the operating frequency of the balun can be easily adjusted. For example, by adjusting values of capacitors C1-C5, the operating frequency of the balun can be changed within the range dictated by the dielectric media used (e.g., at least within an octave of an originally designed operating frequency between 100 MHz and 2.5 GHz) without changing the multilayer structure or adjusting the coupled striplines which are embedded therein. For example, using the values in Table 1 below, a balun according to the exemplary embodiment of Figure 3 can operate within the range of 935-960 MHz. By changing the values of capacitors C1-C5 to those shown in Table 2, the same balun structure can instead operate at between 425-430 MHz. Those skilled in the art will appreciate that other capacitance values can be used to achieve other operating frequency ranges.

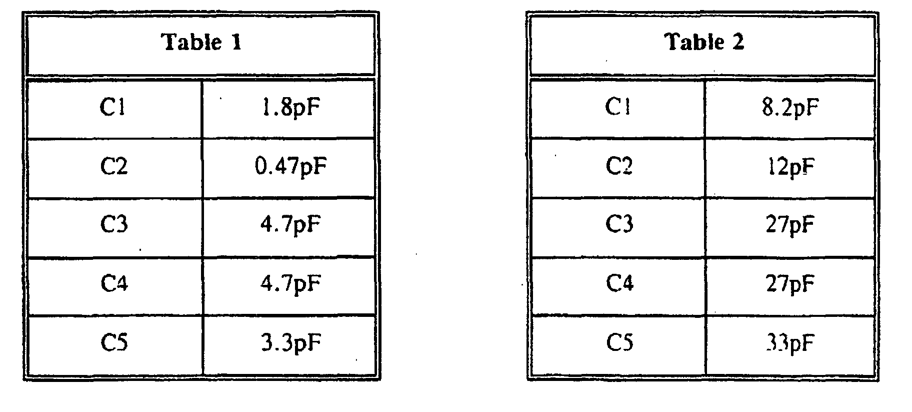

## Claims

1. A balun comprising:
• a non-symmetrical signal port (30) coupled to a first capacitor (C1);
• a first symmetrical signal port (32);
• a second symmetrical signal port (34);
• a top layer (Layer 1) of a multilayer structure (10); and
• a first ground plane layer (Layer N-2) provided beneath said top layer;
**characterized in that** the balun further comprises:
• a coupled pair of stripline elements (S1, S2) provided on a third layer (Layer N-1 ) beneath said ground plane layer, said coupled pair of stripline transmission elements having a first (42), second (44) and third (46) connection nodes, wherein said first capacitor (C1 ) is connected to said first node (42);
• said first symmetrical signal port (32) being connected to said second node (44) of said coupled pair of stripline transmission elements, wherein a combination of a first transmission line element (S3), a second capacitor (C3) and a second transmission line element (S4) are provided between said second node (44) and said first symmetrical signal port (32); and
• said second symmetrical signal port (34) being connected to said third node (46) of said coupled pair of stripline transmission elements, wherein a combination of a third transmission line element (S5), a third capacitor (C4) and a fourth transmission line element (S6) are provided between said third node (46) and said second symmetrical signal port (34);
• wherein said first (C1), second (C3) and third (C4) capacitors are provided on said top layer (Layer 1) of said multilayer structure (10).

2. The balun of claim 1, further comprising: a fourth capacitor (C2), provided on said top layer of said multilayer structure, connected to said first node (42).

3. The balun of claim 2, wherein capacitance values of said first (C1) and fourth (C2) capacitors are selected to provide impedance matching and transformation to said non-symmetrical port (30).

4. The balun of claim 1, further comprising: a fifth capacitor (C5) connected to a common node (38) which interconnects said coupled pair of stripline elements (S1, S2), said fifth capacitor (C5) having a capacitance value selected to maintain outputs of said first and second symmetrical ports at substantially the same amplitude and 180 degrees out of phase with respect to one another.

5. The balun of claim 1, wherein impedance values of said combination of said first transmission line element (S3), said second capacitor (C3) and said second transmission line element (S4) are selected to provide a desired tradeoff between power matching and noise matching to outputs of said first and second symmetrical port.

6. The balun of claim 5, wherein said desired tradeoff is optimal noise matching.

7. The balun of claim 5, wherein said desired tradeoff is optimal power matching.

8. The balun of claim 1, further comprising: a ground plane (Layer N) beneath said third layer (Layer N-1).

9. The balun of claim 1, further comprising: a biasing port (36) for allowing an external device to bias the first and second symmetrical ports.

10. The balun of claim 1, wherein said first (S3) and third (S5) transmission line elements are provided on said third layer (Layer N-1) as striplines and said second (S4) and fourth (S6) transmission line elements are provided on said top layer (Layer 1) as microstrips.

11. The balun of claim 1, wherein said coupled pair of stripline elements (S1, S2) have a fourth node (40) which is connected to said ground plane layer.

12. The balun of claim 1, wherein said first (C1), second (C3) and third (C4) capacitors are also connected to said ground plane layer.

## Patentansprüche

1. Symmetrieschaltung, die folgendes aufweist:
- einen nicht-symmetrischen Signalport (33), der an eine erste Kapazität (C1) gekoppelt ist;
- einen ersten symmetrischen Signalport (32);
- einen zweiten symmetrischen Signalport (34) ;
- eine Oberschicht (Schicht 1) einer Mehrschichtstruktur (10); und
- eine erste Erdungsplattenschicht (Schicht N-2), die unterhalb der Oberschicht vorgesehen ist;
**dadurch gekennzeichnet, dass** die Symmetrieschaltung ferner folgendes aufweist:
- ein gekoppeltes Paar von Streifenleitungselementen (S1, S2), welche an einer dritten Schicht (Schicht N-1) unterhalb der Erdungsplattenschicht vorgesehen sind, wobei das gekoppelte Paar von Streifenleitungselementen einen ersten (42), zweiten (44) und dritten (46) Verbindungsknoten aufweisen, wobei die erste Kapazität (C1) mit dem ersten Verbindungsknoten verbunden ist;
- wobei der erste symmetrische Signalport (32) mit dem zweiten Verbindungsknoten (44) des gekoppelten Paares von Streifenleitungselementen verbunden ist, wobei eine Kombination aus einem ersten Übertragungs-Leitungselement (S3), einer zweiten Kapazität (C3) und einem zweiten Übertragungs-Leitungselement (S4) zwischen dem zweiten Verbindungsknoten (44) und dem ersten symmetrischen Signalport (32) vorgesehen ist; und
- wobei der zweite symmetrische Signalport (34) mit dem dritten Verbindungsknoten (46) des gekoppelten Paares von Streifenleitungselementen verbunden ist, wobei eine Kombination aus einem dritten Übertragungs-Streifenleitungselement (S5), einer dritten Kapazität (C4) und einem vierten Übertragungs-Streifenleitungselement (S6) zwischen dem dritten Verbindungsknoten (46) und dem zweiten symmetrischen Signalport (34) vorgesehen ist;
- wobei die erste (C1), zweite (C3) und dritte (C4) Kapazität an der Oberschicht (Schicht 1) der Mehrschichtstruktur (10) vorgesehen sind.

2. Symmetrieschaltung gemäß Anspruch 1, die ferner folgendes aufweist : eine vierte Kapazität (C2), die an der Oberschicht der Mehrschichtstruktur vorgesehen und mit dem ersten Verbindungsknoten (42) verbunden ist.

3. Symmetrieschaltung gemäß Anspruch 2, wobei die Kapazitätswerte der ersten (C1) und zweiten (C2) Kapazität derart ausgewählt werden, um eine Impedanz-Anpassung und -Transformation für den nicht-symmetrischen Signalport (30) bereitzustellen.

4. Symmetrieschaltung gemäß Anspruch 1, die ferner folgendes aufweist: eine fünfte Kapazität (C5), die mit einem Gemeinschafts-Verbindungsknoten (38) verbunden ist, welcher das gekoppelte Paar von Streifenleitungselementen (S1, S2) und die fünfte Kapazität (C5) untereinander verbindet, welche einen derart ausgewählten Kapazitätswert hat, um die Ausgaben des ersten und des zweiten symmetrischen Signalports bei der im wesentlichen gleichen Amplitude und untereinander um 180° phasenverschoben zu halten.

5. Symmetrieschaltung gemäß Anspruch 1, wobei die Impedanzwerte der Kombination aus dem ersten Übertragungs-Leitungselement (S3), der zweiten Kapazität (C3) und dem zweiten Übertragungs-Leitungselement (S4) derart ausgewählt werden, um einen erwünschten Kompromiss bzw. eine gewünschte Abwägung zwischen Leistungsanpassung und Rauschanpassung für Ausgaben des ersten und zweiten symmetrischen Signalports bereitzustellen.

6. Symmetrieschaltung gemäß Anspruch 5, wobei der erwünschte Kompromiss bzw. die erwünschte Abwägung die optimale Rauschanpassung ist.

7. Symmetrieschaltung gemäß Anspruch 5, wobei der erwünschte Kompromiss bzw. die erwünschte Abwägung die optimale Leistungsanpassung ist.

8. Symmetrieschaltung gemäß Anspruch 1, die ferner folgendes aufweist: eine Erdungsplatte (Schicht N) unterhalb der dritten Schicht (Schicht N-1).

9. Symmetrieschaltung gemäß Anspruch 1, die ferner folgendes aufweist: ein Vorspannungs-Signalport (36), um es einer externen Vorrichtung zu gestatten, den ersten und zweiten symmetrischen Signalport vorzupolen.

10. Symmetrieschaltung gemäß Anspruch 1, wobei das erste (S3) und das dritte (S5) Übertragungs-Leitungselement an der dritten Schicht (Schicht N-1) als Streifenleitungen und das zweite (S4) und vierte (S6) Übertragungs-Leitungselement als Mikrostreifen an der Oberschicht (Schicht 1) vorgesehen sind.

11. Symmetrieschaltung gemäß Anspruch 1, wobei das gekoppelte Paar von Streifenleitungselementen (S1, S2) einen vierten Verbindungsknoten (40) aufweisen, der mit der Erdungsplattenschicht verbunden ist.

12. Symmetrieschaltung gemäß Anspruch 1, wobei die erste (C1), zweite (C3) und dritte (C4) Kapazität ebenso mit der Erdungsplattenschicht verbunden sind.

## Revendications

1. Symétriseur comprenant :
• un port de signal non symétrique (30) couplé à un premier condensateur (C1) ;
• un premier port de signal symétrique (32) ;
• un deuxième port de signal symétrique (34) ;
• une couche supérieure (couche 1) d'une structure multicouche (10) ; et
• une première couche de plan de masse (couche N-2) prévue en dessous de ladite couche supérieure ;
**caractérisé en ce que** le symétriseur comprend en outre :
• une paire couplée d'éléments de ligne à ruban (S1, S2) prévue sur une troisième couche (couche N-1) en dessous de ladite couche de plan de masse, ladite paire couplée d'éléments de transmission à ligne à ruban ayant un premier (42), un deuxième (44) et un troisième (46) noeuds de connexion, dans laquelle ledit premier condensateur (C1) est connecté audit premier noeud (42) ;
• ledit premier port de signal symétrique (32) étant connecté audit deuxième noeud (44) de ladite paire couplée d'éléments de transmission à ligne à ruban, dans lequel une combinaison d'un premier élément de ligne de transmission (S3), d'un deuxième condensateur (C3) et d'un deuxième élément de ligne de transmission (S4) est prévue entre ledit deuxième noeud (44) et ledit premier port de signal symétrique (32) ; et
• ledit deuxième port de signal symétrique (34) étant connecté audit troisième noeud (46) de ladite paire couplée d'éléments de transmission à ligne à ruban, dans lequel une combinaison d'un troisième élément de ligne de transmission (S5), d'un troisième condensateur (C4) et d'un quatrième élément de ligne de transmission (S6) est prévue entre ledit troisième noeud (46) et ledit deuxième port de signal symétrique (34) ;
• dans lequel lesdits premier (C1), deuxième (C3) et troisième (C4) condensateurs sont prévus sur ladite couche supérieure (couche 1) de ladite structure multicouche (10).

2. Symétriseur selon la revendication 1, comprenant en outre un quatrième condensateur (C2) prévu sur ladite couche supérieure de ladite structure multicouche, connecté audit premier noeud (42).

3. Symétriseur selon la revendication 2, dans lequel des valeurs de capacité desdits premier (C1) et quatrième (C2) condensateurs sont sélectionnées pour fournir une adaptation et transformation d'impédance audit port non symétrique (30).

4. Symétriseur selon la revendication 1, comprenant en outre un cinquième condensateur (C5) connecté à un noeud commun (38) qui s'interconnecte à ladite paire couplée d'éléments de ligne à ruban (S1, S2), ledit cinquième condensateur (C5) ayant une valeur de capacité sélectionnée pour maintenir des sorties desdits premier et deuxième ports symétriques à fondamentalement la même amplitude et 180 degrés de déphasage l'un par rapport à l'autre.

5. Symétriseur selon la revendication 1, dans lequel des valeurs d'impédance de ladite combinaison dudit premier élément de ligne de transmission (S3), dudit deuxième condensateur (C3) et dudit deuxième élément de ligne de transmission (S4) sont sélectionnées pour fournir un compromis voulu entre l'adaptation de puissance et l'adaptation de bruit aux sorties desdits premier et deuxième ports symétriques.

6. Symétriseur selon la revendication 5, dans lequel ledit compromis voulu est l'adaptation de bruit optimale.

7. Symétriseur selon la revendication 5, dans lequel ledit compromis voulu est l'adaptation de puissance optimale.

8. Symétriseur selon la revendication 1, comprenant en outre un plan de masse (couche N) en dessous de ladite troisième couche (couche N-1).

9. Symétriseur selon la revendication 1, comprenant en outre un port de polarisation (36) permettant à un dispositif extérieur de polariser les premier et deuxième ports symétriques.

10. Symétriseur selon la revendication 1, dans lequel lesdits premier (S3) et troisième (S5) éléments de ligne de transmission sont prévus sur ladite troisième couche (couche N-1) sous forme de lignes à ruban et lesdits deuxième (S4) et quatrième (S6) éléments de ligne de transmission sont prévus sur ladite couche supérieure (couche 1) sous forme de microrubans.

11. Symétriseur selon la revendication 1, dans lequel ladite paire couplée d'éléments de ligne à ruban (S1, S2) a un quatrième noeud (40) qui est connecté à ladite couche de plan de masse.

12. Symétriseur selon la revendication 1, dans lequel lesdits premier (C1), deuxième (C3) et troisième (C4) condensateurs sont également connectés à ladite couche de plan de masse.
